# Europäisches Patentamt
# European Patent Office
# Office européen des brevets

(11) Numéro de publication: **0 189 710**
**B1**

(12) **FASCICULE DE BREVET EUROPÉEN**

(45) Date de publication du fascicule du brevet:
25.01.89

(51) Int. Cl.⁴: **H 01 L 27/14**, G 01 T 1/00

(21) Numéro de dépôt: 85402611.9

(22) Date de dépôt: 24.12.85

(54) Dispositif photosensible de grand format, et procédé d'utilisation.

(30) Priorité: 27.12.84 FR 8419919

(43) Date de publication de la demande:
06.08.86 Bulletin 86/32

(45) Mention de la délivrance du brevet:
25.01.89 Bulletin 89/4

(84) Etats contractants désignés:
DE GB NL

(56) Documents cité:
EP-A-0 028 960
EP-A-0 060 752
GB-A-1 258 572
US-A-4 146 904

(73) Titulaire: THOMSON- CSF, 173, Boulevard Haussmann, F-75379 Paris Cédex 08 (FR)

(72) Inventeur: Rougeot, Henri, THOMSON- CSF SCPI 173, bld Haussmann, F-75379 Paris Cedex 08 (FR)

(74) Mandataire: Mayeux, Michèle, THOMSON- CSF SCPI 19, avenue de Messine, F-75008 Paris (FR)

## Description

La présente invention concerne un dispositif photosensible de grand format. Elle concerne également un procédé d'utilisation d'un tel dispositif.

Le dispositif photosensible de grand format selon l'invention est plus particulièrement destiné à la détection d'images radiologiques, mais il peut être utilisé pour la détection d'autres types de rayonnement, comme le rayonnement visible par exemple.

Dans le domaine de la détection d'images radiologiques, on cherche à remplacer les films radiologiques de façon à obtenir l'information radiologique sous forme de signal électrique ce qui a notamment pour avantage de permettre le traitement d'image.

En ce qui concerne l'art antérieur sur la suppression des films radiographiques, on peut citer l'utilisation de panneaux plats, impressionnés par rayonnement X et lus par rayonnement laser. On peut aussi citer l'utilisation de barrettes de détecteurs qui défilent devant le corps émettant le rayonnement X. On connaît dans l'art antérieur (voir par exemple EP-A-0 028 960 qui de plus décrit un dispositif photosensible de grand formant réalisé en technologie film mince et ayant une structure différente de la présente invention) des matrices de détection d'un rayonnement électromagnétique qui sont constituées de transistors à effet de champ à jonction ou JFET. Ces transistors sont périodiquement mis à l'état bloqué par une impulsion appliqué sur leur grille qui est ensuite laissée flottante. Le rayonnemnt reçu par chaque transistor réduit l'épaisseur de la couche désertée sous sa grille, provoque l'ouverture de son canal, et donc le déblocage du transistor. Lors de l'application d'une impulsion de lecture au drain ou à la source de chaque transistor, il circule entre le drain et la source un courant dont l'intensité est fonction du rayonnement reçu par chaque transistor. Ces matrices sont généralement réalisées en matériaux semiconducteurs monocristallins qui ne se prêtent pas à des grands formats.

La présente invention concerne une structure originale de dispositif photosensible de grand format.

Le dispositif photosensible de grand format selon l'invention présente notamment les avantages suivants:
- possibilité d'obtention d'un format radiologique, égal par exemple au format 36x43 cm$^2$;
- encombrement réduit égal à celui d'une cassette radiologique;
- adaptation possible sur un équipement radiographique existant;
- performances électro-optiques supérieures à celles d'un film radiographique;
- performances compatibles avec la radiographie médicale en ce qui concerne par exemple la dose de saturation, la dynamique, la résolution, le temps d'inscription, la durée de restitution de l'image, le traitement d'image...
- grande sensibilité;
- obtention en un temps très court de signaux électriques permettant le traitement d'image.

La présente invention concerne un dispositif photosensible de grand format comportant:
- un substrat semi-conducteur en silicium amorphe hydrogéné, légèrement dopé N;
- l'une des faces de ce substrat semi-conducteur portant les éléments suivants superposés:
- des plots, appelés grilles flottantes, de forme sensiblement retangulaire, avec une ouverture centrale, qui sont répartis selon des lignes et des colonnes, ces plots étant réalisés en un matériau constituant une jonction avec le substrat semi-conducteur;
- une couche de matériau isolant;
- un réseau de grilles de commande disposées suivant les contours des grilles flottantes;
- l'autre face du substat semi-conducteur portant les éléments suivants superposés:
- des plots conducteurs, appelés drains, qui sont situés au niveau des ouvertures centrales des grilles flottantes et des électrodes en forme d'échelle, appelées sources, qui sont disposées selon les colonnes de grilles flottantes, et qui respectivement circonscrivent les grilles flottantes de la colonne correspondante:
- des connexions qui relient entre eux les drains situés au-dessus de chaque ligne de grilles flottantes.

D'autres objets, caractéristiques et résultats de l'invention ressortiront de la description suivantes, donnée à titre d'exemple non limitatif et illustrée par les figures annexées qui représentent:
- la figure 1, une vue en perspective d'un mode de réalisation d'un dispositif photosesible selon l'invention;
- la figure 2, une vue de dessus du dispositif de la figure 1;
- les figures 3 à 6, des vues en coupe illustrant la remise à zéro, l'inscription et la lecture du dispositif selon l'invention.

Sur les différentes figures, les mêmes repères désignent les mêmes éléments, mais, pour des raisons de clarté, les cotes et proportions des divers éléments ne sont pas respectées.

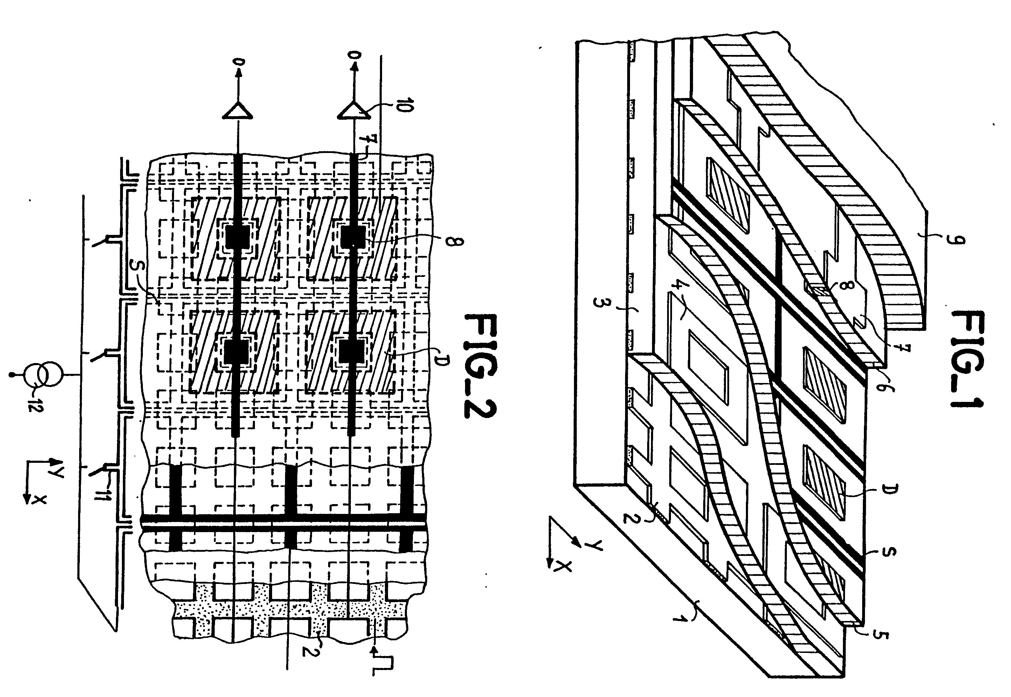

La figure 1 est une vue en perspective d'un mode de réalisation d'un dispositif photosensible selon l'invention.

Un substrat en matériau isolant 1, tel que du verre, de l'alumine, du quartz, ou de la silice fondue par exemple, est recouvert sur l'une de ses faces par un réseau de grilles conductrices 2, appelées grilles de commande dans ce qui suit. Ces grilles sont déposées selon deux directions perpendiculaires, référencées X et Y sur la figure 1.

L'ensemble de la surface du substsrat 1 qui porte les grilles de commande, est recouvert d'une couche de matériau isolant 3, par exemple en silice ou en nitrure de silicium.

Sur la couche de matériau isolant 3, on dépose une mosaïque de plots 4 que l'on va désigner dans ce qui suit sous le terme de grilles flottantes.

Ces grilles flottantes ont sur la figure 1 une forme rectangulaire, avec une ouverture centrale également rectangulaire.

Elle sont réparties en matrice selon des lignes-direction X- et selon des colonnes - direction Y.

Ces grilles flottantes sont realisées en un matériau constituant une jonction avec le substrat semi-conducteur 5 en silicium amorphe hydrogéné, légèrement dopé N, qui les recouvre, comme on le verra par la suite.

Ces grilles peuvent donc être constituées par exemple de silicium polycristallin ou amorphe, dopé P. Elles peuvent aussi être réalisées en métal, en platine par exemple, de façon à réaliser des jonctions Schottky.

Il est bien entendu que l'on peut utiliser des grilles flottantes de forme différente de celle représentée sur la figure 1, par exemple de forme carrée avec une ouverture centrale carréé ou rectangulaire.

Quelle que soit la forme adoptée pour les grilles flottantes, on utilise un réseau de grilles de commande 2, déposées suivant les contours des grilles flottantes, comme on peut le voir sur la figure 1.

On dépose sur les grilles flottantes le substrat semiconducteur 5 en silicium amorphe hydrogéné, légèrement dopé N, dont il a déjà été question précédemment.

Ce type de semi-conducteur possède des propriétés photoconductrices. Pour obtenir un substrat semi-conducteur en silicium amorphe hydrogéné, légèrement dopé N, on réalise une compensation en utilisant un corps tel que le bore par exemple. Cette compensation permet de diminuer le dopage de type N du silicium amorphe hydrogéné.

On sait fabriquer des panneaux de grand format en silicium amorphe hydrogéné. On peut donc obtenir des panneaux en silicium amorphe hydrogéné aux dimensions radiographiques, au format 36x43 cm$^2$ par exemple.

On dépose ensuit des électrodes sur le substrat semiconducteurs 5.

On dépose deux types d'électrodes:
- d'une part, des plots conducteurs, appelés drains D, qui sent situés au niveau des ouvertures centrales des grilles flottantes 4;
- d'autre part, des électrodes en forme d'échelles, appelées sources, qui circonscrivent les grilles flottantes et qui sont disposées selon les colonnes de grilles flottantes, c'est-à-dire selon la direction Y comme on peut le voir sur la figure 1.

On dépose ensuite sur ces électrodes une couche de matériau isolant 6 qui porte des connexions 7 et 8 reliant entre eux les drains 3 situés au-dessus de chaque ligne de grilles flottantes, selon la direction X. Les connexions 7 et 8 sont réalisées en un matériau conducteur transparent, tel que de l'oxyde d'indium ou d'étain. De même, le matériau isolant 6 doit être transparent. Il peut être réalisé en nitrure de silicium ou en oxyde de silicium.

Les électrodes de drains D et de sources S peuvent être réalisées par implantation de phosphore dans le substrat semiconducteur 5. Cette implantation peut être réalisée à travers la couche isolante 6.

Les électrodes de drains D et de sources S peuvent également être réalisées par lithographie après traitement du substrat semiconducteur 5 pour obtenir du silicium amorphe dopé N.

Lorsqu'on utilise le dispositif photosensible pour la détection d'images radiologiques, on dépose sur la couche de matériau isolant 6 portant les connexions 7 et 8 une couche de scintillateur 9 qui transforme le rayonnement X en rayonnement visible auquel la couche 6 et les connexions 7 doivent être transparentes.

Ces scintillateurs sont réalisés de façon connue dans des matériaux tels que par exemple des halogénures alcalins, du sulfure de zinc ou de cadmium, du tungstate de zinc ou de cadmium, des oxy-sulfures de terre rare, ou de l'oxy-sulfure de gadolinium avec un liant organique...

Il faut remarquer que la couche isolante 1 n'est pas indispensable au fonctionnement et joue essentiellement un rôle de protection.

De même, la couche isolante 6 peut être supprimée dans le cas où le dispositif selon l'invention est utilisé pour la détection d'images radiologiques et nécessite l'utilisation d'un scintillateur.

Il est possible de déposer les connexions 7 directement sur la couche de scintillateur 9 qui est isolante et d'effectuer des liaisons 8 entre ces connexions 7 et les drains D. Un avantage de ce mode de réalisation est que les connexions 7 et 8 n'ont pas à être transparentes au rayonnement transmis par le scintillateur.

La figure 2 est une vue de dessus du dispositif de la figure 1.

On constate que chaque connexion 7 entre drains D est reliée à un amplificateur de sortie 10. Chaque électrode de source en échelle 5 est reliée à un multiplexeur 11, représenté de façon symbolique et connecté à une source de courant 12.

Les amplificateurs de sortie 10 et le multiplexeur 11 peuvent être déposés sur le substrat isolant 1 sur lequel est également déposé le reste du dispositif photosensible. Pour réaliser les amplificateurs de.sortie, on peut utiliser par exemple des transistors du type JFET réalisés sur du silicium polycristallin.

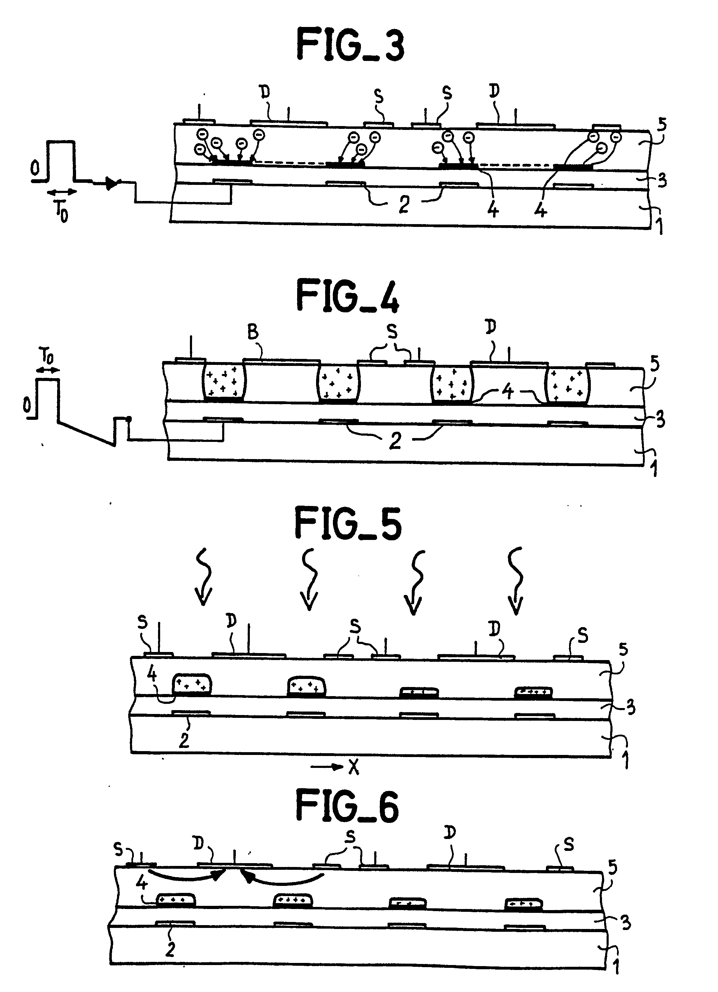

Le fonctionnement du dispositif selon l'invention va être expliqué en se référant aux figures 3 à 6 qui sont des vues en coupe du dispositif de la figure 1.

Sur ces figures, on n'a pas représenté pour des raisons de clarté la couche d'isolant 6 et la couche de scintillateur 9.

Les figures 3 et 4 illustrent la remise à zéro du panneau.

Une impulsion positive est appliquée aux grilles de commande 2. Elle est transmise par effet capacitif aux grilles flottantes 4.

Les diodes constituées par les grilles flottantes 4 et par le substrat semi-conducteur 5 se trouvent alors polarisées en sens direct ou passant.

Des charges négatives s'accumulent sur les grilles flottantes 4. Après un temps To, les grilles de commande 4 sont ramenées au potentiel de la masse du dispositif. Comme cela est illustré sur la figure 4, les grilles flottantes conservent leurs charges négatives et induisent de ce fait des charges positives liées dans le substrat semiconducteur 5. Les diodes constituées par les grilles flottantes 4 et par le substrat semi-conducteur 5 sont bloquées. La conduction entre les électrodes de source périphériques S et le drain central D est alors bloquée par obstruction complète des canaux surplombant les grilles flottantes 4.

La figure 5 illustre l'inscription d'informations dans le dispositif photosensible selon l'invention.

Ce dispositif reçoit un rayonnement lumineux symbolisé par des flèches ondulées sur la figure.

Ce rayonnement peut provenir du scintillateur mais il peut aussi s'agir directement du rayonnement à détecter.

La lumière produite élargit les canaux surplombant les grilles flottantes 4. On rappelle que ces canaux avaient été totalement obstrués lors de la remise à zéro - voir figure 4.

Sur la figure 5, on a représenté de façon symbolique que l'ouverture des canaux varie selon la quantité de lumière reçue par chaque grille flottante 4.

La figure 6 illustre la lecture des informations lumineuses reçues par le dispositif selon l'invention.

Un procédé de lecture consiste à relever le courant à la sortie de tous les amplificateurs alors que le multiplexeur 11 relie successivement chaque source en forme d'échelle S à la source de courant 12.

On mesure ainsi successivement l'état de chaque canal entre la source périphérique et le drain central.

Chaque canal à mesurer est figé dans un état déterminé qui dépend de l'intensité lumineuse qu'il a reçue.

L'intensité du courant circulant entre la source et le drain d'un détecteur mesure la charge totale neutralisée lors de l'inscription.

Il suffit d'une faible génération de porteurs dans le canal pour faire varier largement le courant entre source et drain.

La charge collectée sur chaque drain dépend du temps T de lecture. On règle donc le gain du dispositif en agissant sur le temps de lecture T.

Une génération thermique de porteurs tend à ouvrir chaque canal en l'absence de toute excitation extérieure. Pour éviter d'avoir à en tenir compte et à corriger le signal de sortie recueilli, on applique aux grilles de commande après l'impulsion positive de durée To une rampe négative.

Cette rampe négative est représentée sur la figure 4. Elle a pour effet de ramener sur les grilles flottantes 4 les charges négatives perdues du fait de la génération thermique. On donne de préférence à cette rampe négative une durée telle que lors de la lecture des détecteurs la rampe négative soit terminée.

On a calculé de façon théorique les caractéristiques du dispositif selon l'invention telles que la dose de saturation, la dynamique, la résolution, le temps d'inscription, la durée de restitution de l'image...

Pour cela, on a assimilé chaque détecteur à quatre transistors à effet de champ linéaires, juxtaposés, à la périphérie d'un drain central.

Les caractéristiques du dispositif selon l'invention sont compatibles avec la radiographie médicale.

**Revendications**

1. Dispositif photosensible de grand format comportant:
- un substrat semi-conducteur (5, en silicium amorphe hydrogéné, légèrement dopé N;
- l'une des faces de ce substrat semi-conducteur (5) portant les éléments suivants superposes:
- des plots, appelés grilles flottantes (4), de forme sensiblement rectangulaire, avec une ouverture centrale, qui sont répartis selon des lignes (X) et des colonnes (Y), ces plots étant réalisés en un matériau constituant une jonction avec le substrat semi- conducteur (5);
- une couche de matériau isolant (3);
- un réseau de grilles de commande (2) disposées suivant les contours des grilles flottantes (4);
- l'autre face du substrat semi-conducteur (5) portant les éléments suivants superposés:
- des plots conducteurs, appelés drains (D), qui sont situés au niveau des ouvertures centrales des grilles flottantes (4) et des électrodes en forme d'échelle, appelées surce (S), qui sont disposées selon les colonnes (Y) de grilles flottantes, et qui respectivement circonscrivent les grilles flottantes (4) de la colonne (Y) correspondante;
- des connexions (7, 8) qui relient entre eux les drains (D) situés au-dessus de chaque ligne de grilles flottantes (4).

2. Dispositif photosensible de grand format selon la revendication 1, caractérisé en ce que
- une couche de matériau isolant transparent (6) recouvre la face du substrat semi-conducteur (5) portant les drains (D) et les sources (S);
- les connexions (7, 8) qui relient les drains d'une même ligne sont également transparentes et sont portées par cette couche isolante (6).

3. Dispositif photosensible de grand format selon la revendication 2, caractérisé en ce qu'une couche de scintillateur (9) recouvre la couche isolante (6) portant les connexions (7, 8) entre les drains d'une même ligne.

4. Dispositif photosensible de grand format selon la revendication 1, caractérisé en ce que:
- une couche de scintillateur (9) recouvre la face du substrat semi-conducteur (5) partant les drains (D) et les sources (S);
- les connexions (7, 8) qui relient les drains d'une même ligne sont portées par cette couche de scintillateur (9).

5. Dispositif photosensible de grand format selon l'une des revendications 1 à 4, caractérisé en ce que le réseau de grilles de commande (2) est déposé sur une couche de matériau isolant (1).

6. Dispositif photosensible de grand format selon l'une des revendication 1 à 5, caractérisé en ce que chaque connexion (7) entre les drains (D) est reliée à un amplificateur de sortie (10).

7. Dispositif photosensible de grand format selon l'une des revendications 1 à 6, caractérisé en ce que chaque électrode de source (S) en échelle est reliée à un multiplexeur (11) connecté à une source de courant (12).

8. Dispositif photosensible de grand format selon l'une des revendication 6 ou 7, caractérisé en ce que les amplificateurs de sortie (10) ou/et le multiplexeur (11) sont réalisés sur la couche de matériau isolant (1) portant les grilles de commande (2).

9. Procédé d'utilisation d'un dispositif photosensible de grand format selon l'une des revendications 1 à 8, caractérisé en ce que la remise à zéro du dispositif s'effectue en appliquant une impulsion positive aux grilles de commande (2), puis en les ramenant au potentiel de la masse du dispositif.

10. Procédé d'utilisation d'un dispositif photosensible de grand format selon la revendication 9, caractérisé en ce que la lecture du dispositif s'effectue en relevant le courant à la sortie des amplificateurs de sortie (10), alors que le multiplexeur (12) relie successivement chaque source (S) en forme d'échelle à la source de courant (12).

11. Procédé d'utilisation d'un dispositif photosensible de grand format selon l'une des revendications 9 ou 10, caractérisé en ce que la remise à zéro du dispositif s'effectue en faisant suivre l'impulsion positive d'une rampe négative.


**Patentansprüche**

1. Großformatige lichtempfindliche Vorrichtung die umfaßt:
- ein Halbleitersubstrat (5) aus amorphem wasserstoffhaltigem, leicht N-dotiertem Silizium;
- folgende, auf einer Seite des Halbleitersubstrates (5) übereinandergeschichtete Elemente:
- Elektroden genannt Gate (13) mit unbestimmtem Potential, von im wesentlichen rechteckiger Form, mit einer zentralen Öffnung, wobei die Elektroden entlang von Zeilen (X) und Spalten (Y) verteilt sind und aus einem Material bestehen, das eine Verbindung mit dem Halbleitersubstrat (5) bildet;
- einer Schicht aus isolierendem Material (3);
- ein Netz aus Steuergates (2), die entlang der Umrisse der Gates (4) mit unbestimmtem Potential verlaufen;
- folgende, auf der anderen Seite des Halbleitersubstrats (5) übereinandergeschichtete Elemente:
- Elektroden, genannt Drain (D) die in den zentralen Öffnungen der Gates (4) mit unbestimmtem Potential angeordnet sind, sowie Elektroden in Sprossenleiterform, genannt Source (S), welche entlang der Spalten (Y) der Gates mit unbestimmtem Potential verlaufen und jeweils die Gates (4) der entsprechenden Spalte (Y) umgrenzen;
- Verbindungen (7, 8), welche die über jede Zeile der Gates (4) mit unbestimmtem Potential angeordneten Drains (D) untereinander verbinden.

2. Großformatige lichtempfindliche Vorrichtung nach Anspruch 1, dadurch gekennzeichnet, daß:
- eine Schicht aus isolierendem, transparentem Material (6) diejenige Seite des Halbleitersubstrats (5) bedeckt, welche die Drain-(D) und die Source-Elektroden (S) trägt;
- die Verbindungen (7, 8) welche die Drain-Elektroden einer Zeile verbinden, ebenfalls transparent sind und von dieser isolierenden Schicht (6) getragen werden.

3. Großformatige lichtempfindliche Vorrichtung nach Anspruch 2, dadurch gekennzeichnet, daß eine Szintillatorschicht (9) die isolierende Schicht (6) bedeckt, welche die Verbindungen (7, 8) zwischen den Drain-Elektroden einer Zeile tragen.

4. Großformatige lichtempfindliche Vorrichtung nach Anspruch 1, dadurch gekennzeichnet, daß:
- eine Szintillatorschicht (9) diejenige Seite des Halbleitersubstrats bedeckt, welche die Drain-(D) und die Source-Elektroden (S) trägt;
- die Verbindungen (7, 8), welche die Drain-Elektroden einer Zeile verbinden, von dieser Szintillatorschicht getragen werden.

5. Großformatige lichtempfindliche Vorrichtung nach einem der Ansprüche 1 bis 4, dadurch gekennzeichnet, daß das Netz der Steuergates (2) auf einer Schicht aus isolierendem Material (1) aufgebracht ist.

6. Großformatige lichtempfindliche Vorrichtung nach einem der Ansprüche 1 bis 5, dadurch gekennzeichnet, daß jede Verbindung (7) zwischen den Drain-Elektroden (D) mit einem Ausgangsverstärker (10) verbunden ist.

7. Großformatige lichtempfindliche Vorrichtung nach einem der Ansprüche 1 bis 6, dadurch gekennzeichnet, daß jede sprossenleiterförmige Source-Elektrode (S) mit einem Multiplexer (11) verbunden ist, der an eine Stromquelle (12) angeschlossen ist.

8. Großformatige lichtempfindliche Vorrichtung nach einem der Ansprüche 6 oder 7, dadurch gekennzeichnet, daß die Ausgangsverstärker (10) und/oder der Multiplexer (11) auf der Schicht aus Isoliermaterial (1) angebracht sind, welche die Steuergares (2) trägt.

9. Verfahren zur Benutzung einer großformatigen lichtempfindlichen Vorrichtung nach einem der Ansprüche 1 bis 8, dadurch gekennzeichnet, daß das Nullsetzen der Vorrichtung durch Anlegen eines Positiven Impulses an die Steuergates (2) und anchließendes Überführen derselben auf das Massepotential der Vorrichtung erfolgt.

10. Verfahren zur Benutzung einer großformatige lichtempfindlichen Vorrichtung nach Anspruch 9, dadurch gekennzeichnet daß das Lesen der Vorrichtung durch Erfassung des Ausgangsstromes der Ausgangsverstärker (10) erfolgt, während der Multiplexer (12) nacheinander jede sprossenleiterförmige Source-Elektrode (5) an die Stromquelle (12) schaltet.

11. Verfahren zur Benutzung einer großformatigen lichtempfindlichen Vorrichtung nach einem der Ansprüche 9 oder 10, dadurch gekennzeichnet, daß die Nullsetzung der Vorrichtung dadurch erfolgt, daß man eine negativen Rampe auf den Positiven Impuls folgen läßt.

**Claims**

1. A large photosensitive device, comprising:
- a semiconductor substrate (5) of hydrogenated amorphous and slightly N-doped silicon;
- one face of the semiconductor substrate (5) bearing the following superimposed elements:
- connection studs, referred to as floating gates (4) having substantially rectangular shape, distributed along the lines (X) and columns (Y) said connection studs being made of a material constituting a junction with the semiconductor substrate (5);
- a layer of insulating material (3);
- a network of control gates (2) disposed along the contours of the floating gates (4);
- the other face of the semiconductor substrate (5) bearing the following superimposed elements:
- conducting connection studs, referred to as drains (D), located in the central openings of the floating gates (4), and electrodes having the shape of a ladder, referred to as sources (S), which are disposed along the columns (Y) of the floating gates and circumscribe respectively the floating gates (4) of the corresponding column (V);
- connections (7, 8) interconnecting the drains (D) located above each line of the floating gates (4).

2. A large photosensitive device according to claim 1, characterized in that:
- a layer of insulating transparent material (6) covers that face of the semiconductor substrate (5) which bears the drains (D) and the sources (S);

- the connections (7, 8) which interconnect the drains of a line are also transparent and are born by said insulating layer (6).

3. A large photosensitive device according to claim 2, characterized in that a scintillator layer (9) covers the insulating layer (6) which bears the connections (7, 8) between the drains of a line.

4. A large photosensitive device according to claim 1, characterized in that:
- a scintillator layer (9) covers that face of the semiconductor substrate (5) which bears the drains (D) and the sources (S);
- the connections (7, 8) which interconnect the drains of a line are born by said scintillator layer (9).

5. A large photosensitive device according to one of claims 1 to 4, characterized in that the network of control gates (2) is deposited upon a layer of insulating material (1).

6. A large photosensitive device according to one of claims 1 to 5, characterized in that each connection (7) between the drains (D) is coupled to an output amplifier (10).

7. A large photosensitive device according to one of claims 1 to 6, characterized in that each ladder shaped source electrode (5) is coupled to a multiplexer (11) which is connected to a current source (12).

8. A large photosensitive device according to any one of claims 6 or 7, characterized in that the output amplifiers (10) and/or the multiplexer (11) are made on the layer of insulating material (1), which bears the control gates.

9. A method of using a large photosensitive device according to any one of claims 1 to 8, characterized in that the zero setting of the device is made by applying a positive pulse to the control gates (2), and then by applying to said gates the mass potential of the device.

10. A method of using a large photosensitive device according to claim 9, characterized in that the reading of the device is performed by measuring the current at the output of the output amplifiers (10), while the multiplexer (12) connects successively each ladder-shaped source (S) to the current source (12).

11. A method of using a large photosensitive device according to any one of claims 9 or 10, characterized in that the zero setting of the device is made by applying a negative ramp after the positive pulse.

# FIG_1

# FIG_2

# FIG_3

# FIG_4

# FIG_5

# FIG_6